# EUROPEAN PATENT APPLICATION

(11) **EP 3 442 315 A1**
(43) Date of publication of application: **13.02.2019**
(21) Application number: 18187416.5
(22) Date of filing: 06.08.2018
(51) Int. Cl.: H05K 5/00

(54) **ELECTRONIC DEVICE**

(30) Priority: 07.08.2017 JP 2017152328
(71) Applicant: Kabushiki Kaisha Tokai Rika Denki Seisakusho, Ohguchi-cho Niwa-gun Aichi 480-0195 (JP)
(72) Inventor: KUROIWA, Takao, Aichi, 480-0195 (JP); OGAWA, Satoshi, Aichi, 480-0195 (JP)
(74) Representative: Betten & Resch

(57) **Abstract**

Provided is an electronic device capable alleviating stress acting on a joining portion of a board and a pin header. An electronic device (1) is generally configured to include a board (4) on which an electronic component (46) is arranged, a pin header (5) electrically connected to the electronic component (46) and attached to the board (4), a connector housing (6) having a connector section (60) to be a connector by the pin header (5) being inserted in the connector section (60), and a lower housing (2) having an opening (25) into which the connector section (60) in which the pin header (5) is inserted is inserted.

## Description

### Technical Field

The present invention relates to an electronic device.

### Related Art

In the related art, such an electronic control device is well-known that includes an electronic circuit board on which a pin header used for an electrical connection with an external device is mounted along with an electronic component, and also includes a housing configured to accommodate the electronic circuit board and having a connector housing section that is provided as an opening in a position corresponding to the pin header (for example, see JP 2014-187123A).

In the stated electronic control device, the housing is constituted of a base and a cover including the connector housing section. Further, in the electronic control device, the cover and the pin header are configured to have a first positioning structure by press fitting. Accordingly, the positioning between the cover and the pin header can be carried out with ease and with high correctness.

### Summary of Invention

However, in the electronic control device of the related art, because the positioning of the cover and the pin header is prioritized, there is a possibility that stress acts on a joining portion of the electronic circuit board and the pin header to cause a pin position shift of the pin header, a conduction failure, or the like, after the cover and the base are fitted to each other, due to a shift of a formation position of the opening, a position shift of the pin header and the electronic circuit board, or the like.

As such, an object of the invention is to provide an electronic device capable of alleviating the stress acting on a joining portion of a board and a pin header.

An aspect of the invention provides an electronic device including a board on which an electronic component is arranged, a pin header electrically connected to the electronic component and attached to the board, a connector housing having a connector section to be a connector by the pin header being inserted in the connector section, and a first housing having an opening into which the connector section in which the pin header is inserted is inserted.

### Effects of Invention

According to an aspect of the invention, the stress acting on a joining portion of the board and the pin header can be alleviated.

### Brief Description of Drawings

FIG. 1 is an exploded view illustrating an example of an electronic device according to an embodiment.
FIG. 2A is a perspective view illustrating an example of a front surface side of an electronic device according to an embodiment.
FIG. 2B is a perspective view illustrating an example of a back surface side.
FIG. 3A is a schematic view illustrating an example of an electronic device according to an embodiment before an upper housing thereof being fitted.
FIG. 3B is a cross-sectional view illustrating an example of a cross section, taken along a III(b)-III(b) line in FIG. 3A, in a view from an arrow direction.
FIG. 3C is a schematic view illustrating an example of a gap between an opening and a connector section.
FIG. 4A is a front view illustrating an example of a connector housing according to an embodiment.
FIG. 4B is a plan view illustrating an example of the connector housing.
FIG. 4C is a bottom view illustrating an example of the connector housing.
FIG. 4D is a side view illustrating an example of the connector housing.

### Description of Embodiments

### Overview of Embodiments

An electronic device according to an embodiment is generally configured to include a board on which an electronic component is arranged, a pin header electrically connected to the electronic component and attached to the board, a connector housing having a connector section to be a connector by the pin header being inserted in the connector section, and a first housing having an opening into which the connector section in which the pin header is inserted is inserted.

In the stated electronic device, the connector housing in which the pin header is inserted is inserted into the opening of the first housing and serves as a connector. Because of this, the stress acting on a joining portion of the board and the pin header can be alleviated in comparison with a case in which the above configuration is not employed.

### Embodiment

### Outline of Electronic Device 1

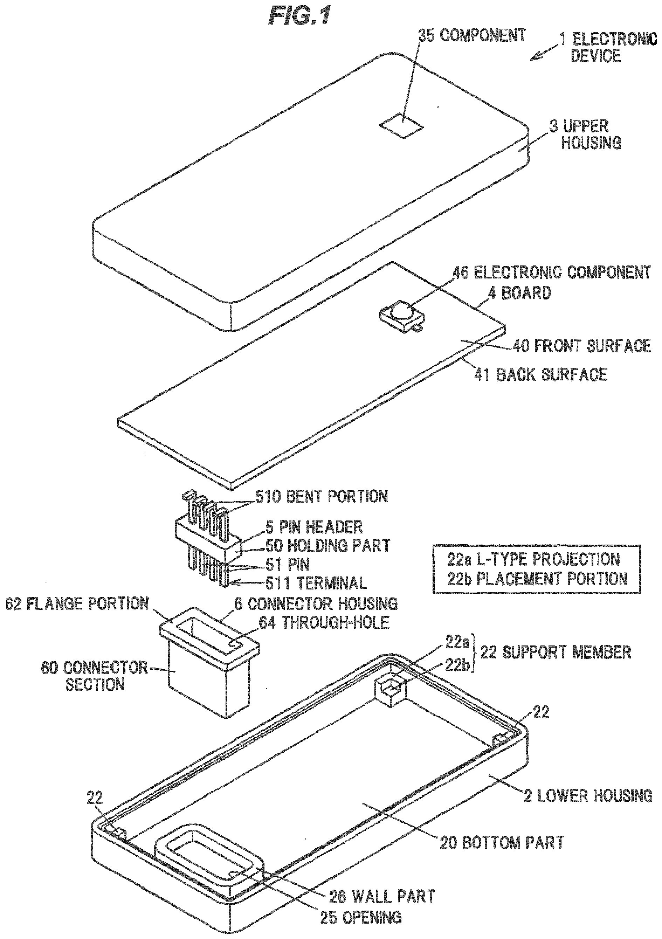

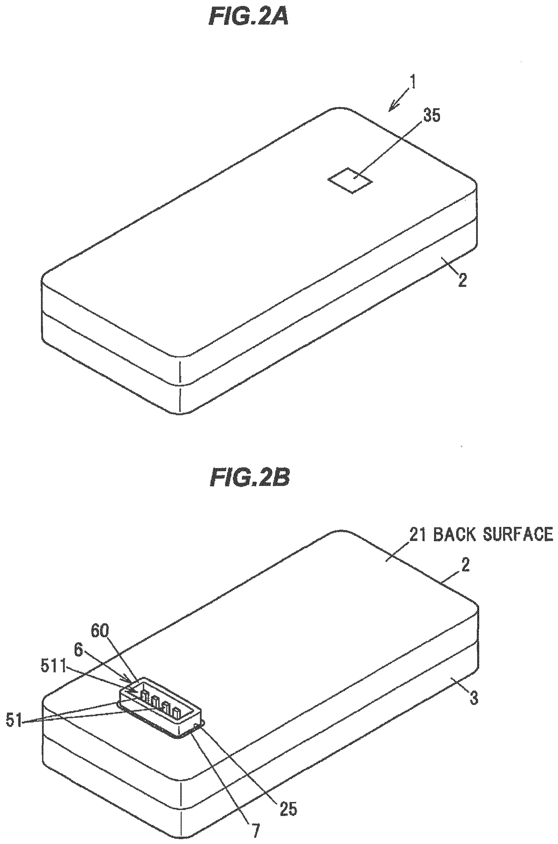

FIG. 1 is an exploded view illustrating an example of an electronic device according to an embodiment. FIG. 2A is a perspective view illustrating an example of a front surface side of the electronic device according to the embodiment, and FIG. 2B is a perspective view illustrating an example of a back surface side thereof. In the drawings associated with the following embodiments, ratios between elements in the drawings may be different from the actual ratios.

For example, as illustrated in FIGS. 1, 2A, and 2B, the electronic device 1 is generally configured to include a board 4 on which an electronic component 46 is arranged, a pin header 5 electrically connected to the electronic component 46 and attached to the board 4, a connector housing 6 having a connector section 60 to be a connector by the pin header 5 being inserted in the connector section 60, and a lower housing 2 as a first housing having an opening 25 into which the connector section 60 in which the pin header 5 is inserted is inserted.

The electronic device 1 is installed in a vehicle, for example, and is connected with a connector on the vehicle side. Note that the electronic device 1 is not limited to being installed in the vehicle. Although, as an example, the electronic device 1 of the present embodiment is simply configured to include a light-emitting element as the electronic component 46 and a lens as a component 35, the electronic device 1 is not limited to the above configuration, and can be used as various types of electronic devices. That is, the electronic device 1 may be an air conditioning device, a navigation device, or the like including a display portion on which characters, images, and the like are displayed, an operation unit for changing set values or the like, and the like.

### Configurations of Lower Housing 2 and Upper Housing 3

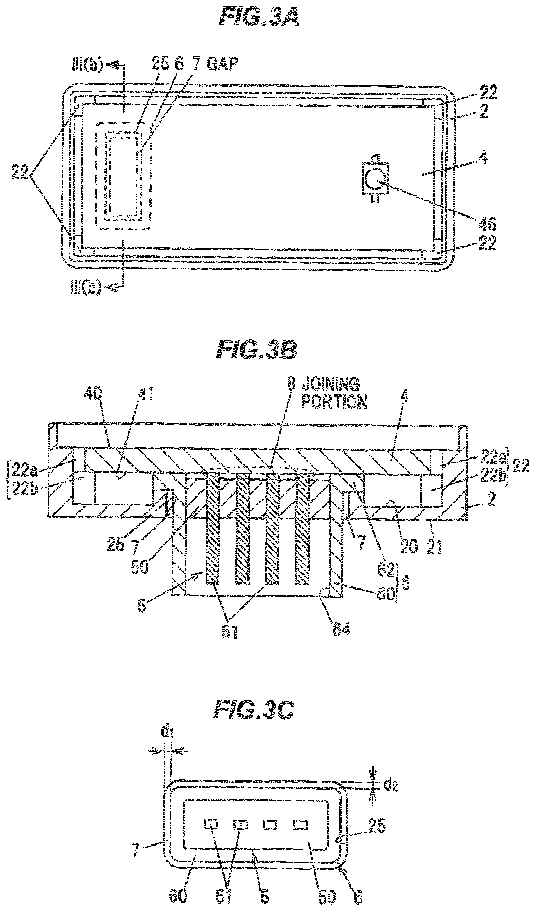

FIG. 3A is a schematic view illustrating an example of the electronic device of the embodiment before an upper housing thereof being fitted. FIG. 3B is a cross-sectional view illustrating an example of a cross section, taken along a III(b)-III(b) line in FIG. 3A, in a view from an arrow direction. FIG. 3C is a schematic view illustrating an example of a gap between the opening and the connector section.

The lower housing 2 and an upper housing 3 are formed using a resin material such as Acrylonitrile Butadiene Styrene (ABS) resin. Although, as an example, each of the lower housing 2 and the upper housing 3 has an elongate shape, the shape thereof is not limited thereto.

For example, as illustrated in FIG. 1, the lower housing 2 includes support members 22 in four corners of a bottom part 20. The support members 22 support the board 4 as illustrated in FIGS. 3A and 3B, for example.

To be specific, each of the support members 22 includes, for example, an L-type projection 22a formed in a substantially L shape and a placement portion 22b, which is provided at a lower portion of the L-type projection 22a and on which a corner of the board 4 is placed.

The L-type projection 22a is provided in such a manner as to rise from an edge of the placement portion 22b, for example, and serves as a positional reference when the board 4 is arranged in the lower housing 2. The placement portions 22b support the board 4 by supporting four corners of the board 4. In the upper housing 3, there is provided a projection configured to make contact with the board 4 and pinch the board 4 along with the lower housing 2, for example. The support members 22 may be provided in the upper housing 3, not in the lower housing 2.

The lower housing 2 includes the opening 25 into which the connector housing 6 is to be inserted. Around this opening 25, a wall part 26 is provided in such a manner as to surround the opening 25 on the bottom part 20 side. A flange portion 62 of the inserted connector housing 6 makes contact with the wall part 26, as illustrated in FIG. 3B, for example. By the contact between the flange portion 62 and the wall part 26, the connector housing 6 is restricted from sliding out of the lower housing 2.

As a modification example, the wall part 26 may be configured as follows: an O-ring is arranged on an upper portion of the wall part 26, and the wall part 26 pinches the O-ring along with the flange portion 62, thereby preventing dust, liquid, or the like from entering from exterior. The wall part 26 and the flange portion 62 may be bonded to each other with an adhesive.

For example, as illustrated in FIG. 3C, the opening 25 includes a gap 7, between the inserted connector housing 6 and the opening 25, configured to allow a position shift generated at a time when the board 4 is arranged in the lower housing 2. The gap 7 is set such that, in the drawing of FIG. 3C, a distance d₁ in a short-side direction and a distance d₂ in a longitudinal direction are respectively secured for the gap in a case where the connector housing 6 is arranged in the center of the opening 25. Each of the distance d₁ and the distance d₂ is several millimeters, for example.

In the case where the board 4 is arranged being fitted to the support members 22 in the lower housing 2, the positions of the board 4 and the lower housing 2 are adequately determined. However, there is a possibility that the positions of the opening 25 and the pin header 5 are shifted because of being distanced from the support members 22.

In a case where, for example, a connector section is integrally formed on a lower housing in an electronic device, in a case where the positions of the connector section and a pin header are shifted, the positions thereof do not match each other when the pin header is inserted in the connector section. As a result, deformation of the board is generated at a time when the connector is inserted or extracted, a switch is operated in a case of the stated switch being arranged on the board, or the like. Because of this, there arises a possibility that unexpected stress acts on a joining portion of the board and the pin header to cause a trouble such as peeling of the pin. Further, in the case where the positioning of the connector section and the pin header is carried out being prioritized in the electronic device, for example, there also arises a possibility that unexpected stress acts on the joining portion of the board and the pin header to cause the trouble because of the positions of the board and the lower housing being shifted.

However, in the present embodiment, the pin header 5 is inserted into a through-hole 64 of the connector housing 6, and then the connector housing 6 in which the pin header 5 is inserted is inserted into the opening 25 of the lower housing 2 formed in such a manner as to allow the position shift, thereby making it possible to obtain high correctness of the positioning of the components and suppress the stress acting on a joining portion 8 of the board 4 and the pin header 5.

Further, the upper housing 3 includes the component 35 configured to function in cooperation with the electronic component 46 arranged on the board 4, for example. The component 35 is, for example, a lens. That is, "to function in cooperation with the electronic component 46" means that "the lens as the component 35 functions as an indicator in cooperation with a light-emitting element as the electronic component 46 arranged on the board 4", for example. In a case where the component configured to function in cooperation with the electronic component 46 is a switch, the electronic component 46 is a microswitch, and a push button as the component 35 to actuate the microswitch is arranged on the upper housing 3. Further, in a case where the component configured to function in cooperation with the electronic component 46 is a rotational operation unit, the electronic component 46 is a rotation-amount detector configured to detect an amount of rotation, and the component 35 is a dial.

As discussed above, in the case where a component configured to function in cooperation with an electronic component is arranged on the upper housing, in a case where the positioning of the pin header and the connector section integrally formed on the lower housing is prioritized, the positions of the board and the lower housing are shifted, and consequently the positions of the board and the upper housing are shifted. Because of this shift, the position of the component configured to function in cooperation with the electronic component on the board and the position of the stated electronic component are shifted, thereby raising a possibility that the function is not normally implemented.

However, in the present embodiment, as discussed above, the positioning of the board 4 and the lower housing 2 is carried out being prioritized, and thus the shift in position between the upper housing 3 and the board 4 is suppressed. Moreover, in the electronic device 1, although the positioning of the board 4 and the lower housing 2 is prioritized, the positions of the pin header 5 and the connector housing 6 are adequately determined only by inserting the pin header 5 into the through-hole 64. Because of this, the positioning of the lower housing 2 and the board 4, the positioning of the pin header 5 and the connector housing 6, and the positioning of the boar 4 and the upper housing 3 are carried out with high correctness.

### Configuration of Board 4

Although the board 4 is, for example, a printed wiring board and has an elongate plate-like shape in accordance with the shapes of the lower housing 2 and the upper housing 3, the shape of the board 4 is not limited thereto.

On a front surface 40 of the board 4, the electronic component 46 such as a light-emitting element is arranged, for example, to configure an electronic circuit along with other electronic components. As illustrated in FIG. 3B, the pin header 5 is surface-mounted on a back surface 41 of the board 4; the back surface 41 is positioned on the lower housing 2 side. An area where the pin header 5 is mounted is, for example, the joining portion 8 indicated by a dotted line in FIG. 3B.

In the joining portion 8, a bent portion 510 of the pin header 5 and wiring of the board 4 are joined to each other using solder in a state where the bent portion 510 is in contact with the board 4.

### Configuration of Pin Header 5

As illustrated in FIG. 1, the pin header 5 is generally configured to include a holding part 50 and a plurality of pins 51, for example. Although, as an example, the number of pins 51 in the present embodiment is four, the number thereof is not limited thereto.

The holding part 50 is formed in a square pole shape using a resin material such as Poly Butylene Terephtalate (PBT), for example. The holding part 50 has a shape to be fitted into the through-hole 64 of the connector housing 6.

Through-holes are provided in the holding part 50 corresponding to the pins 51, and the pins 51 are inserted in the stated through-holes whereby the pins 51 are held. The through-holes are aligned at a predetermined pitch.

The pins 51 are formed using an electrically conductive material such as phosphor bronze, for example. The pins 51 are plated with gold, where nickel is an underlying metal, for example. Further, each of the pins 51 includes the bent portion 510 formed by, for example, bending one end portion of the pin 51 in an L shape, and also includes a terminal 511 as the other end portion thereof to be a terminal of the connector.

The bent portion 510 is joined to wiring formed on the back surface 41 of the board 4 via solder. The terminal 511 is exposed inside the connector section 60 of the connector housing 6 and serves as a terminal of the connector. The method for joining is not limited to soldering, and another method such as adhesive joining or welding may be employed.

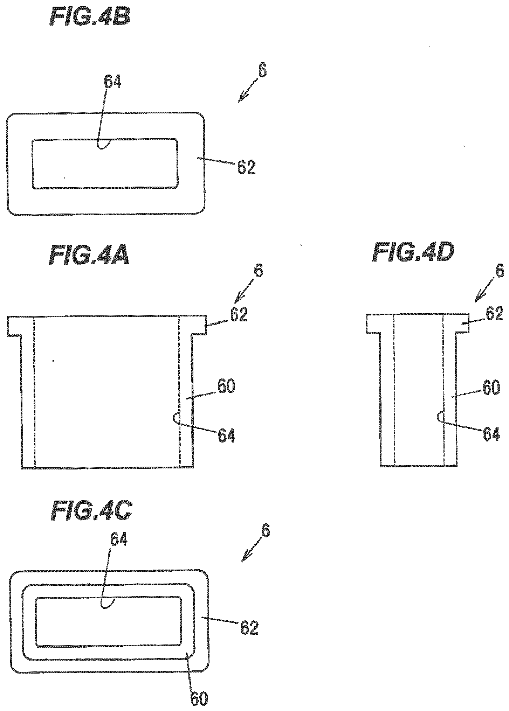

Configuration of Connector Housing 6
FIG. 4A is a front view illustrating an example of the connector housing according to the present embodiment, FIG. 4B is a plan view illustrating the example of the connector housing, FIG. 4C is a bottom view illustrating the example of the connector housing, and FIG. 4D is a side view illustrating the example of the connector housing.

The connector housing 6 is formed using a resin material such as nylon or fluororesin, for example. As illustrated in FIG. 3B and FIGS. 4A to 4D, for example, the connector housing 6 is generally configured to include the connector section 60 and the flange portion 62 provided on a circumference of the connector section 60 and pinched between the board 4 and the lower housing 2.

The connector section 60 is formed in a cylindrical shape as illustrated in FIGS. 4A to 4D, for example. The hole of the cylinder is the through-hole 64, and has a cross-sectional shape corresponding to the holding part 50 of the pin header 5.

As illustrated in FIGS. 2B and 3B, the connector section 60 is inserted into the opening 25 from the bottom part 20 side of the lower housing 2 and projects from a back surface 21 thereof, for example.

A partner-side connector is inserted into the through-hole 64 in the connector section 60. The inserted partner-side connector is joined to the pins 51 of the pin header 5 and is electrically connected to the electronic circuit of the board 4. That is, the connector section 60 functions as a connector of the electronic device 1.

The flange portion 62 is formed in such a manner as to surround the through-hole 64. The flange portion 62 is a portion pinched between the board 4 and the wall part 26 provided in the periphery of the opening 25 when the connector housing 6, the pin header 5, and the board 4 are fitted to the lower housing 2.

### Manufacturing Method for Electronic Device 1

A manufacturing method for the electronic device 1 includes the following processes: joining the pin header 5 to the board 4 first; inserting the above joined pin header 5 into the through-hole 64 from the flange portion 62 side of the connector housing 6; arranging, in the lower housing 2, the board 4 on which the pin header 5 and the connector housing 6 are integrated while inserting the connector section 60 of the connector housing 6 into the opening 25 to fit the board 4 to the support members 22 of the lower housing 2; and then attaching the upper housing 3 to the lower housing 2.

### Effect of Embodiments

The electronic device 1 according to the present embodiment can alleviate the stress acting on the joining portion 8 of the board 4 and the pin header 5. In the electronic device 1, the pin header 5 joined to the board 4 is inserted in the connector housing 6, and the connector section 60 of the connector housing 6 is inserted into the opening 25 in the lower housing 2; along with this, the positioning of the lower housing 2 and the board 4 can be carried out. As such, in the electronic device 1, since the lower housing 2 and the connector housing 6 to serve as the connector are configured as separate members, the stress acting on the joining portion 8 of the board 4 and the pin header 5 can be alleviated in comparison with a case in which the above configuration is not employed.

In the electronic device 1, since the gap 7 is provided between the opening 25 of the lower housing 2 and the connector section 60, even in a case where the positions of the opening 25 and the connector section 60 are shifted from each other due to the positioning of the lower housing 2 and the board 4, the connector section 60 is not pushed against the opening 25 and thus the stress acting on the joining portion 8 can be alleviated in comparison with a case in which the above configuration is not employed.

In the electronic device 1, since the connector housing 6 includes the flange portion 62, a situation in which the connector housing 6 slides out of the lower housing 2 can be suppressed in comparison with a case in which the above configuration is not employed.

The electronic device 1 can suppress the stress acting on the joining portion 8 despite prioritizing the positioning of the lower housing 2 and the board 4. Because of this, the function obtained through the cooperation between the electronic component 46 arranged on the board 4 and the component 35 provided on the upper housing 3 normally operates, in comparison with a case in which the above configuration is not employed.

Although several embodiments of the invention and a modified example thereof have been described above, these embodiments and modified example are merely examples, and the invention according to claims is not intended to be limited thereto. Such novel embodiments and a modified example can be implemented in various other forms, and various omissions, substitutions, changes, and the like can be made without departing from the spirit and scope of the invention. In addition, all combinations of the features described in these embodiments and modified example are not necessary to solve the problem. Furthermore, these embodiments and modified example are included within the spirit and scope of the invention and also within the invention described in the claims and the scope of equivalents thereof. Reference Signs List
1 Electronic device
2 Lower housing
3 Upper housing
4 Board
5 Pin Header
6 Connector housing
7 Gap
8 Joining portion
20 Bottom part
21 Back surface
22 Support member
22a L-type projection
22b Placement portion
25 Opening
26 Wall part
35 Component
40 Front surface
41 Back surface
46 Electronic component
50 Holding part
51 Pin
60 Connector section
62 Flange portion
64 Through-hole
510 Bent portion
511 Terminal

## Claims

1. An electronic device comprising:
a board on which an electronic component is arranged;
a pin header electrically connected to the electronic component and attached to the board;
a connector housing including a connector section to be a connector by the pin header being inserted in the connector section; and
a first housing including an opening into which the connector section with the pin header inserted therein is inserted.

2. The electronic device according to claim 1, wherein the connector housing includes the above connector section, and a flange portion that is provided on a circumference of the connector section and is pinched between the board and the first housing.

3. The electronic device according to claim 1 or 2, wherein a gap is formed between the opening and the connector housing inserted in the opening so as to allow a position shift generated at a time when the board is arranged in the first housing.

4. The electronic device according to any one of claims 1 to 3, further comprising a second housing to be attached to the first housing, wherein the second housing includes a component configured to function in cooperation with the electronic component arranged on the board.

5. The electronic device according to claim 1, wherein the connector housing and the first housing are configured as a separate member from each other.

6. The electronic device according to claim 3, wherein said gap is formed on an entire periphery of the connector housing.

7. The electronic device according to claim 1, wherein the first housing further includes support members in four corners thereof and the board is positioned by the support members.
